# EUROPEAN PATENT SPECIFICATION

(11) **EP 0 999 644 B1**
(45) Date of publication and mention of the grant of the patent: **18.08.2004**
(21) Application number: 98830653.6
(22) Date of filing: 28.10.1998
(51) Int. Cl.: H03K 19/0185

(54) **Level shifter electronic device having a very low consumption**
Elektronische Potentialumsetzerschaltung mit sehr geringem Verbrauch
Dipositif électronique décaleur de niveau avec consommation très reduite

(43) Date of publication of application: 10.05.2000
(73) Proprietor: STMicroelectronics S.r.l., 20041 Agrate Brianza (Milano) (IT)
(72) Inventor: Ribellino, Calogero, 93019 Sommatino (Caltanissetta) (IT); Milazzo, Patrizia, 98124 Messina (IT)
(74) Representative: Botti, Mario

(56) References cited:
- US-A- 5 317 249
- US-A- 5 371 419
- US-A- 5 754 480
- PATENT ABSTRACTS OF JAPAN vol. 015, no. 428 (E-1128), 30 October 1991 & JP 03 179814 A (NEC CORP), 5 August 1991
- PATENT ABSTRACTS OF JAPAN vol. 017, no. 418 (E-1408), 4 August 1993 & JP 05 083104 A (NEC CORP), 2 April 1993

## Description

### Field of application

The present invention relates to a level shifter electronic device with very low power consumption.

More in particular, the present invention relates to a device of the above mentioned type supplied between a first reference of power supply voltage and a second reference of voltage and comprising a differential cell circuital portion having an output terminal and at least a first and a second input terminal, on the output terminal a signal being drawn which is translated in level with respect to the signal present on one of the input terminals.

The present invention derives from the development of a management device (Power Management) destined to reducing at minimum the power consumption in portable electronic instruments provided with batteries, such as for example cellular phones or portable computer, and the description hereinbelow makes reference to this specific field of application with the only purpose of simplifying the illustration.

The above device is substantially an interface between a battery charger and the main battery of the portable electronic instrument. The main task of this device is that of controlling the charge of the battery.

Further on, other tasks are referable to the above mentioned device, such as: the continuous monitoring of the battery voltage, the charge and the monitoring of the backup battery, the management of the consumption during the different operational states of the portable electronic instrument.

### Prior art

In this specific field of application, the requirement of reducing at the minimum the consumption of the integrated circuits incorporated in the portable electronic instrument and supplied by batteries is particularly felt.

The controllers employed at the moment for this purpose in the modern cellular phones use a very high number of level shifter devices in order to manage at least three different independent power supplies, by interfacing with the digital portion of the UEM device, which operates indeed with different power supplies.

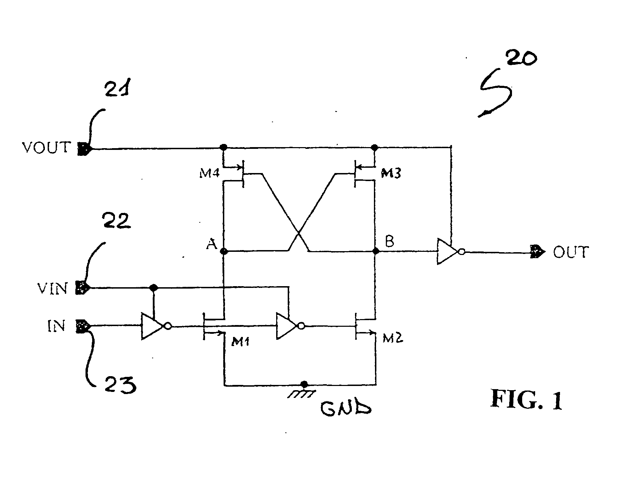

In the hereto attached figure 1 a level shifter 20 with differential cell of known type is shown as example, which is supplied between a first reference 21 of voltage Vout and a mass GND. The shifter 20 has two signal input terminals 22 and 23 and an output terminal OUT.

The power supply Vout corresponds to the value of voltage produced on the output terminal OUT. The first input 22 receives a voltage signal VIN, while the second input 23 receives a signal IN.

Let us suppose that the signal IN on the input 23 be at the logic value "1". In this condition the NMOS transistor M1 is off and the NMOS transistor M2 is on forcing the node B to mass. Accordingly, the PMOS transistor is on and forces the node A to a potential value equal to that of the power supply VOUT. The output OUT has therefore the logic value "1", although it is translated into the value of the power supply VOUT.

If the signal VIN is annulled or off, then also the signal IN is brought to zero in such a way that a voltage value equal to 0V is applied to each of the gate terminals of the transistors M1 and M2. In such a condition, both the nodes A and B remain floating and therefore can position themselves in an indefinite state, thus not ensuring in output a desired logic signal "0" to be compared with the above mentioned values of voltage in input.

The prior art already proposes a solution in order to solve the problem. Such solution consists in foreseeing a component 25 of "pull-up" on the node B so to force the tension in such point to the value of the power supply VOUT when the signal VIN is not present in order to guarantee the logic state "0" on the output OUT.

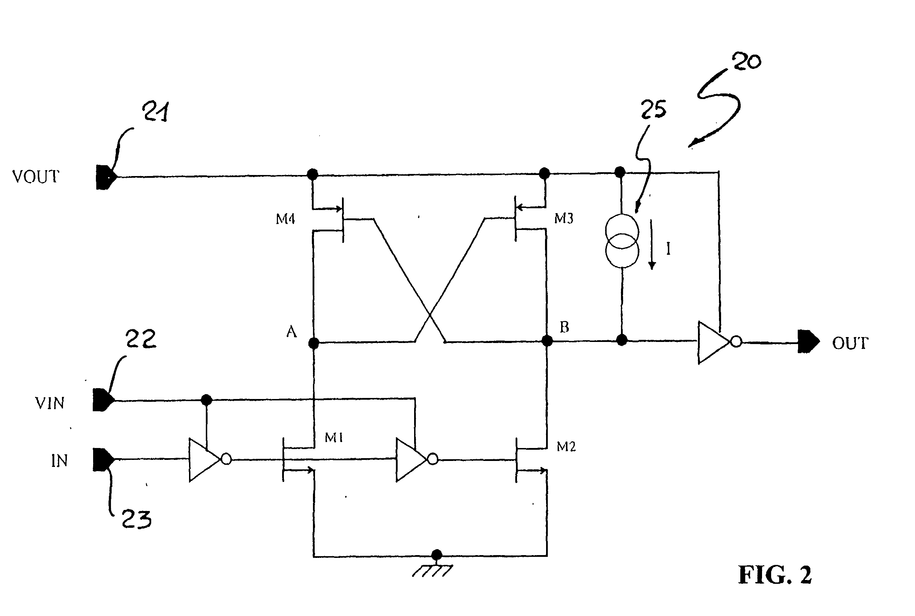

Such a "pull-up" component can be realised in many ways, for example by means of a resistance or with a current generator, as shown in figure 2.

Though advantageous from some points of view, this solution presents anyway also some drawbacks, the most serious of which is that in normal conditions of operation there is a considerable consumption of current I from the power supply to the output. Essentially there is a strong consumption of current I when, in conditions of normal operation, the transistor M2 is on.

Furthermore, the current I must be anyway high enough to ensure that, when the signal VIN becomes null, the node B rapidly achieves the value of VOUT in order to avoid a cross conduction between the transistor M3 and the transistor M2 which form an inverter. This represents therefore a constraint against the actual reduction of such current I.

The technical problem at the basis of the present invention is that of devising a level shifter electronic device having structural and functional characteristics such to allow a very low power consumption in conditions of normal operation, further guaranteeing in output a logic state "0" when the supply voltage of an input becomes null. This would allow to overcome the drawbacks and the limits of the solutions proposed in the art up to now.

### Summary of the invention.

The solution idea which is the basis of the present invention is that of generating inside the level shifter device a local dynamic pull-down with a very low power consumption.

On the basis of this resolutive idea the technical problem is resolved by a device of the type previously indicated and defined by the characterizing part of the hereto attached claims 1 and following.

The features and the advantages of the device according to the invention will be seen from the description, following herein, of an indicative and not limiting example of embodiment given with reference to the attached drawings.

### Brief description of the drawings.

figure 1 shows a schematic view of a level shifter device realised according to the prior art;
figure 2 shows a schematic view of a further example of embodiment of a level shifter realised according to the prior art;
figure 3 shows a schematic view of a level shifter device realised according to the invention;
figure 4A and 4B show schematic views of characteristic diagrams current-voltage corresponding to a known solution and to a solution according to the invention, respectively;
figures 5A, 5B and 5C show on respective diagrams voltage-time the pattern of voltage signals present in the shifter according to the invention.

### Detailed description

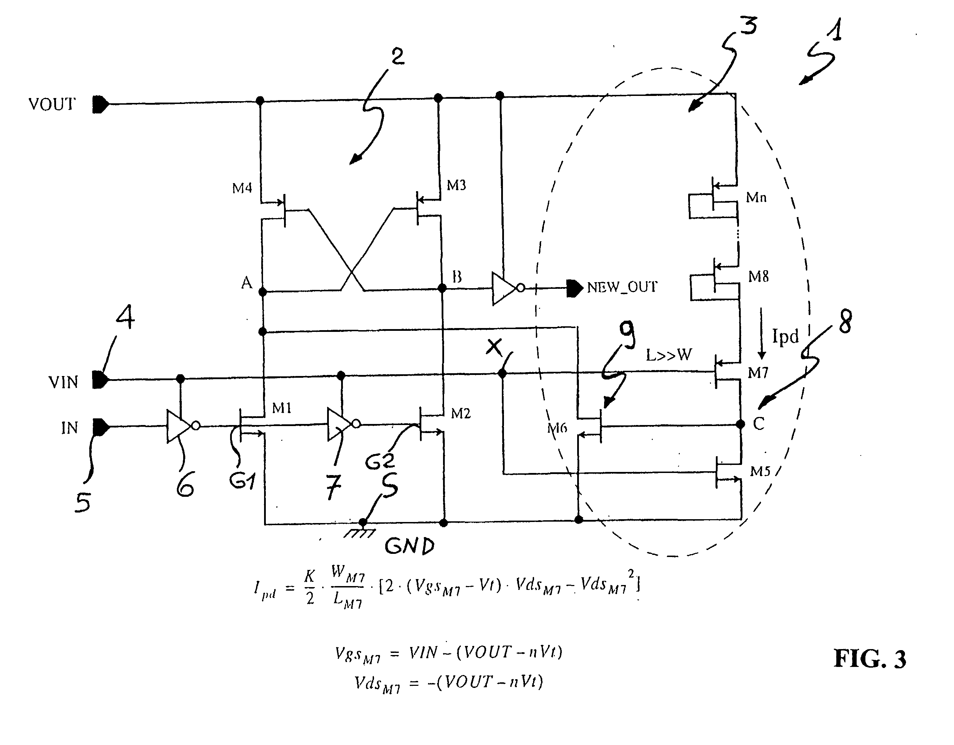

With reference to such figures, and in particular to the example of figure 3, with 1 a level shifter electronic device is in whole and schematically indicated, which is realised according to the present invention, for a charge regulator incorporated in a portable electronic instrument not shown in the drawings as it is of conventional type.

Even if hereinbelow reference shall be made to this specific field of application, it shall be understood that the level shifter according to the invention can find application in any other field where a very low consumption of current in conditions of normal operation is needed.

The shifter device 1 comprises of a first circuital portion 2 with differential cell which is structurally identical to that of a shifter of known type, for example as that illustrated in figure 1. The device 1 further comprises a second additional circuital portion 3 which will be described in detail hereinbelow.

The first circuital portion 2 is supplied between a first voltage reference VOUT of power supply and a second voltage reference GND, for example a mass. The portion 2 is a differential cell and can be considered as formed by two opposite circuital branches, each including an inverter with MOS transistors. The inverters of the two branches are each formed by a complementary pair of transistors and the respective nodes A, B of interconnection between the transistors of each complementary pair are used also to interconnect the two circuital branches.

The differential cell 2 comprises two signal inputs 4, 5 and an output NEW_OUT. This comprises a first pair of NMOS transistors M1 and M2, respectively, having the respective source terminals connected in a common node S connected to the mass GND.

The gate terminal G1 of the transistor M1 is connected to the signal input 5 of the shifter 1 by means of an inverter 6. The gate terminal of the transistor M2 is connected to the gate terminal G1 of the transistor M1 by means of an inverter 7.

The inverters 6 and 7 are supplied by a signal VIN applied to the other signal input 4 of the shifter 1.

The portion 2 comprises also a pair of polarization PMOS transistors M3 and M4, respectively, connected between the first voltage reference VOUT of power supply and the first pair of transistors M1 and M2, respectively.

The drain terminal of the transistor M4 is connected to the gate terminal of the transistor M3 in a node A which coincides with the drain terminal of the transistor M1.

Furthermore, the drain terminal of the transistor M3 is connected to the gate terminal of the transistor M4 in a node B which coincides with the drain terminal of the transistor M3.

Advantageously, according to the invention, the additional circuital portion 3 provides the level shifter 1 with an improved capacity of guaranteeing a low voltage level in the output signal VOUT in absence of input power supply. This is obtained by means of a dynamic pull-down with very low consumption.

To this end, the portion 3 comprises an inverter 8 formed by a complementary pair of transistors M5 and M7, respectively, having the respective gate terminals connected in a common node X connected to the input 4 of the shifter.

The transistor M5 is of NMOS type and is connected to mass GND, whereas the transistor M7 is of PMOS type and is connected to the power supply VOUT.

Advantageously, the geometric ratio L/W of the Length and Width of the channel region of the transistor M7 is dimensioned in such a way that L>>W.

Furthermore, once again according to the present invention, a component 9 of pull-down is foreseen to connect to mass the node A of the differential cell 2. Such component 9 is a MOS transistor M6.

An interconnection node C between the transistors M5 and M7 is connected to the gate terminal of the NMOS transistor M6, which has the source terminal connected to the mass GND and the drain terminal connected to the node A of the portion 2.

A series of transistors M8, .., Mn is inserted between the transistor M7 and the power supply reference VOUT. Such transistors are of PMOS type with a diode configuration with their respective gate and drain terminals short-circuited. In conditions of normal operation of the shifter 1 a current Ipd flows through such transistors.

Let us now analyse the operation of the level shifter device according to the invention.

When the input signal VIN on the input 4 is annulled, the transistor M5 is off and the gate of the transistor M6 (node C) is polarised by means of the series of PMOS transistors M8, .., Mn and of the transistor M7 having L>>W. The number of transistors of the series can be adjusted according to the requirements of the polarization and in order to reduce the consumption of the transistor M5, when this last is on.

The current Ipd that flows in this branch of the circuital portion 3 must be such to bring the voltage on the node C to a threshold voltage value sufficient to charge the gate capacity of the transistor M6, so to switch it on.

In this condition, the node A is forced to mass GND by the transistor M6, the transistor M3 is switched on and forces the node B to the value of the power supply VOUT.

The output NEW_OUT of the level shifter 1 according to the invention is at voltage null, that is at logic value "0".

During a normal operation, that is when the voltage signal VIN is present, the transistor M5 is always on as its gate terminal is directly connected to the input 4 on which the signal VIN is present. This keeps the transistor M6 off.

In this way, the current that flows in the two opposite branches of the first portion 2 is in no way altered by the presence of the additional circuital portion 3.

Differently from the known solution shown in figure 2, the solution according to the invention has a modest consumption of current Ipd, which is the only one provided, focalised in the branch of the portion 3 comprising the series of PMOS transistors. Such consumption of current Ipd is subordinate to the number of PMOS transistors M8, ..., Mn, to the length of the channel of the PMOS transistor M7 and to the difference between the voltage values VIN and VOUT.

In fact, for the shifter according to the invention, the following relationship is true:${\text{Ipd = (K/2) (W}}_{\text{M7}} {\text{/L}}_{\text{M7}} {\text{[2 * (Vgs}}_{\text{M7}} {\text{- Vt) * (Vds}}_{\text{M7}} {\text{- Vds}}_{\text{M7}} {\text{}}^{\text{2}} \text{]}$ with${\text{Vgs}}_{\text{M7}} \text{= VIN - (VOUT - nVt)}$${\text{Vds}}_{\text{M7}} \text{= -(VOUT) - nVt)}$ wherein
n = number of PMOS transistors with short-circuited gate and drain terminals
Vt = threshold voltage of the PMOS transistors with the Body effect being considered.

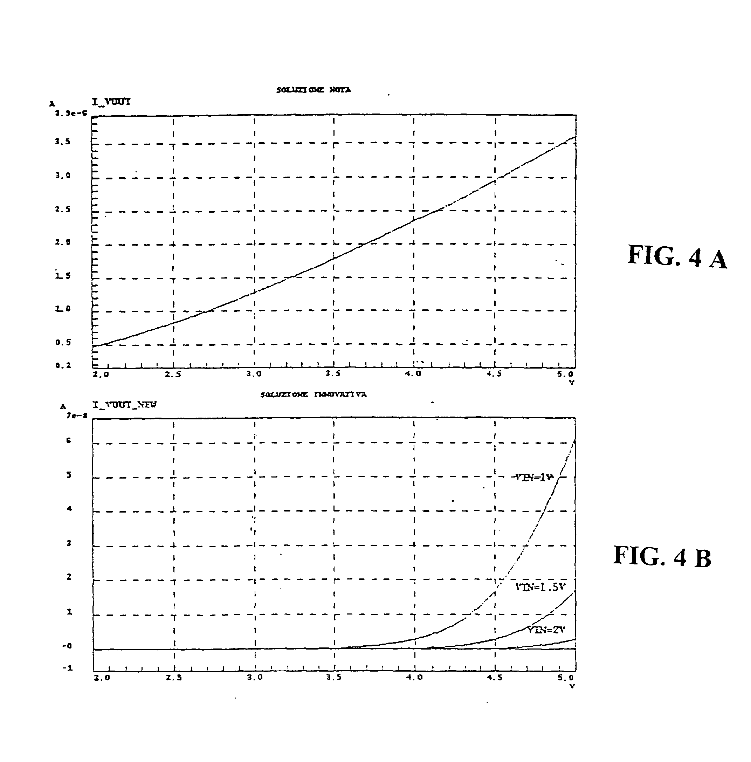

In figures 4A and 4B the results of some electric simulations are shown, which were carried out at the premises of the Applicant on the level shifter according to the invention. In the specific case, a comparison between the invention and the known solution of figure 2 was carried out, wherein a PMOS transistor having the same characteristics of the transistor M7 and with the gate terminal connected to mass was used as current generator I.

For the only purposes of a simulation, the invention was implemented with a series of only three PMOS transistors M8, M9 and M10 respectively, having the respective body terminals connected to the reference of voltage VOUT.

The signal IN was at logic value "1". Therefore, the two circuits were in the worst conditions of operation as far as the consumption of electric current is concerned.

From the comparison between the figures 4A and 4B it is fully apparent that the total savings of current are in favour of the solution according to the present invention. The two diagrams show in particular the amount of current absorbed when the power supply VOUT varies.

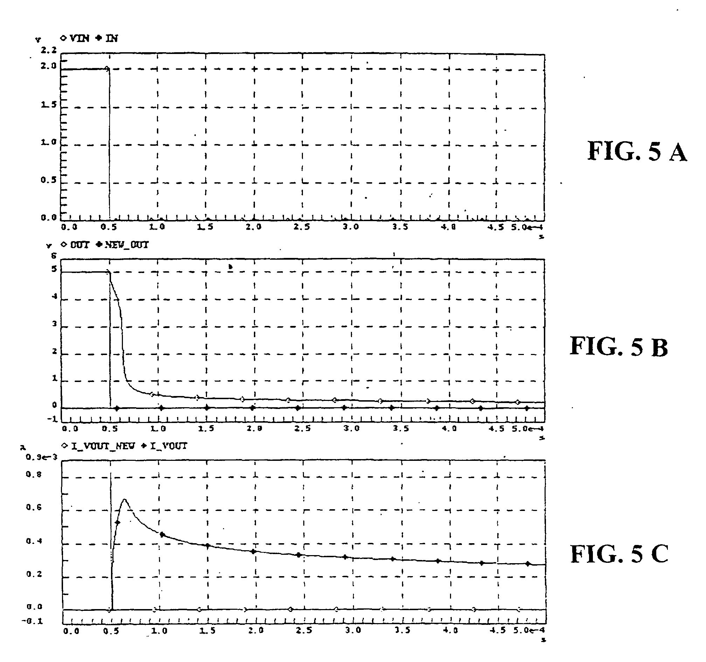

In figures 5A, 5B and 5C, on the contrary, the responses of both circuits, of known type and according to the invention, can be appreciated, when the signal VIN becomes 0 V and in the operative condition when the signal IN is at the logic value "1".

Upon further assumption to design the two circuits in such a way that they have approximately the same consumption of current in operative conditions, the solution according to the invention shows a response to the transient which is much faster, and, above all, does not show any consumption of current after the signal VIN becomes 0 V.

In the known solution of figure 2, on the contrary, a cross-conduction of current due to the low charge of the node B is present.

The invention resolves therefore the proposed technical problem and achieves a number of advantages, the first thereof being for sure that one of providing a low consumption of current in normal conditions of operation.

Further on, the shifter according to the invention do not alter the current that flows in the two branches of the differential stage of the level shifter when the voltage VIN is present.

At equal consumption, the integrated circuital area taken up by the shifter according to the invention is much smaller and the response is much faster.

## Claims

1. Level shifter electronic device with very low power consumption, of the type supplied between a first voltage reference (VOUT) of a power supply and a second voltage reference (GND) and comprising:
- a circuital portion (2) having at least a first input terminal (4) receiving a voltage signal (VIN) and comprising a differential cell which comprises cross-coupled transistors (M3, M4) and a second (5) input terminal receiving an input signal (IN) to be level shifted and an output terminal (OUT) providing a signal translated in level with respect to the voltage signal present on said first input terminal (4), being drawn,
**characterised in that** it further comprises:
- an additional circuital portion (3) receiving said voltage signal (VIN) and providing a pull-down path through at least a pull-down component (9) inserted between a node (A) of the differential cell and the second voltage reference (GND) when said voltage signal (VIN) is absent.

2. Device according to claim 1, **characterised in that** said pull-down component (9) is a MOS transistor (M6) having the conduction terminals connected between said node (A) and the second voltage reference (GND).

3. Device according to claim 1 or 2, **characterised in that** it comprises a series of transistors (M7, M8, ..., Mn) of polarization between a gate terminal of the pull-down component (9) and the first voltage reference (VOUT) of power supply.

4. Device according to claim 3, **characterised in that** said series comprises PMOS transistors some of which have the gate and drain terminals short-circuited.

5. Device according to claim 3, **characterised in that** the first transistor (M7) of said series has the gate terminal connected to said first input terminal.

6. Device according to claim 6, **characterised in that** said first transistor (M7) of the series is dimensioned in such a way that the geometric ratio between the Length L and the Width W of its own channel region is L>>W.

7. Device according to claim 3, **characterised in that** the number of transistors of said series is adjustable according to the requirements of polarisation of said pull-down component (9).

8. Device according to claim 3, **characterised in that** it comprises a further transistor (M5) connected between said series of transistors and the second voltage reference (GND).

9. Device according to claim 8, **characterised in that** said gate terminal of said pull-down transistor (M6) is connected to a node (C) between said further transistor and said series of transistors.

10. Portable electronic instrument of the type incorporating a management device of the recharge of a respective power supply battery, **characterised in that** it comprises at least one level shifter device according to claim 1.

## Patentansprüche

1. Elektronisches Pegelverschiebungsgerät mit äußerst geringer Verlustleistung vom Typ, der zwischen einer ersten Referenzspannung (VOUT) einer Versorgungsspannung und einer zweiten Referenzspannung (GND) liegt, umfassend:
einen Schaltungsteil (2) mit mindestens einem ersten Eingangsanschluss (4), der ein Spannungssignal (VIN) empfängt und eine Differenzialzelle aus kreuzgekoppelten Transistoren (M3, M4) und einen zweiten Eingangsanschluss (5) aufweist, der ein im Pegel zu verschiebendes Eingangssignal (IN) empfängt, außerdem einen Ausgangsanschluss (OUT) besitzt, der ein bezüglich des an dem ersten Eingangsanschluss (4) anstehenden Spannungssignals im Pegel umgesetztes Signal liefert,
**dadurch gekennzeichnet, dass** es weiterhin aufweist:
einen zusätzlichen Schaltungsteil (3), der das Spannungssignal (VIN) empfängt und einen über mindestens ein Pull-down-Bauelement führenden Pulldown-Pfad bildet, der zwischen einen Knoten (A) der Differenzialzelle und die zweite Referenzspannung (GND) eingefügt ist, wenn das Spannungssignal (VIN) nicht vorhanden ist.

2. Gerät nach Anspruch 1, **dadurch gekennzeichnet, dass** das Pull-down-Bauteil (9) ein MOS-Transistor (M6) ist, der mit Leitungsanschlüssen zwischen dem Knoten (A) und die zweite Referenzspannung (GND) gelegt ist.

3. Gerät nach Anspruch 1 oder 2, **dadurch gekennzeichnet, dass** es eine Reihe von Transistoren (M7, M8, ..., Mn) mit Polarisation zwischen einem Gateanschluss des Pull-down-Bauteils (9) und der ersten Referenzspannung (VOUT) der Spannungsversorgung aufweist.

4. Gerät nach Anspruch 3, **dadurch gekennzeichnet, dass** die Reihe PMOS-Transistoren aufweist, von denen einige mit Gate- und Drainanschluss kurzgeschlossen sind.

5. Gerät nach Anspruch 3, **dadurch gekennzeichnet dass** der erste Transistor (M7) der Reihe mit dem Gateanschluss an dem ersten Eingangsanschluss angeschlossen ist.

6. Gerät nach Anspruch 5, **dadurch gekennzeichnet, dass** der erste Transistor (M7) der Reihe derart dimensioniert ist, dass das geometrische Verhältnis zwischen der Länge L und der Breite W seiner eigenen Kanalzone L»W ist.

7. Gerät nach Anspruch 3, **dadurch gekennzeichnet, dass** die Anzahl von Transistoren der Reihe entsprechend den Polarisationsanforderungen des Pull-down-Bauteils (9) einstellbar ist.

8. Gerät nach Anspruch 3, **dadurch gekennzeichnet, dass** es einen weiteren Transistor (M5) aufweist, der zwischen der Reihe von Transistoren und der zweiten Referenzspannung (GND) liegt.

9. Gerät nach Anspruch 8, **dadurch gekennzeichnet, dass** der Gateanschluss des Pull-down-Transistors (M6) an einen Knoten (C) zwischen dem weiteren Transistor und der Reihe von Transistoren angeschlossen ist.

10. Tragbares elektronisches Instrument vom Typ mit einer Managmenteinrichtung für das Wiederaufladen einer Spannungsversorgungsbatterie, **dadurch gekennzeichnet, dass** es mindestens ein Pegelverschiebungsgerät nach Anspruch 1 aufweist.

## Revendications

1. Dispositif électronique de décalage de niveau de très faible consommation électrique, du type alimenté entre une première référence de tension (VOUT) d'une alimentation électrique et une deuxième tension de référence (GND) et comprenant :
- une partie de circuit (2) ayant au moins une première borne d'entrée (4), recevant un signal de tension (VIN) et comportant une cellule différentielle comprenant des transistors à couplages croisés (M3, M4), une deuxième borne d'entrée (5), recevant un signal d'entrée (IN) devant faire l'objet d'un décalage de niveau, et une borne de sortie (OUT) délivrant un signal dont le niveau a été translaté relativement au signal de tension présent sur ladite première borne d'entrée (4), faisant elle-même l'objet de ladite consommation,
- **caractérisé en ce qu'**il comprend, en outre :
- une partie de circuit (3) additionnelle recevant ledit signal de tension (VIN) et fournissant un trajet d'excursion vers le bas, par l'intermédiaire d'au moins un composant d'excursion vers le bas (9) inséré entre un noeud (A) de la cellule différentielle et la deuxième référence de tension (GND) lorsque ledit signal de tension (VIN) est absent.

2. Dispositif selon la revendication 1, **caractérisé en ce que** ledit composant d'excursion vers le bas (9) est un transistor MOS (M6) dont les bornes de conduction sont connectées entre ledit noeud (A) et la deuxième référence de tension (GND).

3. Dispositif selon la revendication 1 ou 2, **caractérisé en ce qu'**il comprend une série de transistors (M7, M8, ..., Mn) de polarisation entre une borne de grille du composant d'excursion vers le bas (9) et la première référence de tension (VOUT) de l'alimentation électrique.

4. Dispositif selon la revendication 3, **caractérisé en ce que** ladite série comprend des transistors PMOS dont certains ont leurs bornes de grilles et de drains court-circuitées.

5. Dispositif selon la revendication 3, **caractérisé en ce que** le premier transistor (M7) de ladite série a sa borne de grille connectée à ladite première borne d'entrée.

6. Dispositif selon la revendication 5, **caractérisé en ce que** ledit premier transistor (M7) de la série est dimensionné de telle manière que le rapport géométrique entre la longueur L et la largeur W de sa propre région de canal soit L » W.

7. Dispositif selon la revendication 3, **caractérisé en ce que** le nombre de transistors de ladite série est susceptible d'être ajusté suivant les exigences de polarisation dudit composant d'excursion vers le bas (9).

8. Dispositif selon la revendication 3, **caractérisé en ce qu'**il comprend un autre transistor (M5) connecté entre ladite série de transistors et la deuxième référence de tension (GND).

9. Dispositif selon la revendication 5, **caractérisé en ce que** ladite borne de grille dudit transistor d'excursion vers le bas (M6) est connectée à un noeud (C) entre ledit autre transistor et ladite série de transistors.

10. Instrument électronique portatif du type incorporant un dispositif de gestion de la recharge d'une batterie d'alimentation électrique respective, **caractérisé en ce qu'**il comprend au moins un dispositif de décalage de niveau selon la revendication 1.
